# EUROPEAN PATENT SPECIFICATION

(11) **EP 1 146 574 B1**
(45) Date of publication and mention of the grant of the patent: **08.08.2007**
(21) Application number: 01109143.6
(22) Date of filing: 12.04.2001
(51) Int. Cl.: H01L 51/00, C09K 11/06, H05B 33/14

(54) **Process for production of an organic luminescence device**
Verfahren zur Herstellung einer organischen lumineszenten Vorrichtung
Procédé de fabrication d'un dispositif organique luminescent

(30) Priority: 14.04.2000 JP 2000112866
(43) Date of publication of application: 17.10.2001
(73) Proprietor: CANON KABUSHIKI KAISHA, Ohta-ku, Tokyo (JP)
(72) Inventor: Senoo, Akihiro, Tokyo (JP); Kawai, Tatsundo, Tokyo (JP); Osato, Yoichi, Tokyo (JP); Hashimoto, Yuichi, Tokyo (JP); Suzuki, Koichi, Tokyo (JP); Tanabe, Hiroshi, Tokyo (JP); Ueno, Kazunori, Tokyo (JP); Mashimo, Seiji, Tokyo (JP)
(74) Representative: TBK-Patent

(56) References cited:
- EP-A- 0 964 045
- WO-A-96/20253
- DE-A- 19 643 097
- US-A- 5 442 021
- DATABASE CAPLUS [Online] CHEMICAL ABSTRACTS SERVICE, COLUMBUS, OHIO, US; NAITO, KATSUYUKI: "Organic electroluminescent devices" retrieved from STN Database accession no. 121:241370 XP002225143 -& JP 06 096860 A (TOKYO SHIBAURA ELECTRIC CO, JAPAN) 8 April 1994 (1994-04-08) -& PATENT ABSTRACTS OF JAPAN vol. 18, no. 355 (E-1573), 5 July 1994 (1994-07-05) & JP 06 009686 A (TOSHIBA CORP), 8 April 1994 (1994-04-08) -& JP 06 096860 A (TOSHIBA CORP) 8 April 1994 (1994-04-08)
- FALBE J: "Römpp Chemie Lexikon" 1995, GEORG THIEME VERLAG STUTTGART * page 81 * * page 3416 *

## Description

The present invention relates to a process for production of an organic (electro-)luminescence device having a film of organic compound capable of light emission under application of an electric field.

An organic luminescence device generally comprises a pair of electrodes (comprising an anode and a cathode) and a film comprising a fluorescent organic compound disposed between the electrodes. Into the organic compound layer (film), holes and electrons are injected from the anode and the cathode, respectively, thus forming excitons of the fluorescent organic compound. When the excitons are returned to ground state, the organic luminescence device emits light or causes luminescence.

According to a study by Eastman Kodak Co. ("Appl. Phys. Lett.", vol. 51, pp. 913- (1987)), it has been reported that a function-separation type organic luminescence layer comprising mutually laminated two layers including a layer of an aluminum quinolinol complex (as an electron transporting and luminescent material) and a layer of a triphenylamine derivative (as a hole transporting material) causes luminescence at a luminance (brightness) of ca. 1,000 cd/m² under application of a voltage of ca. 10 volts. This is also reported in, e.g., U.S. Patent Nos. 4,539,507; 4,720,432 and 4,885,211.

Further, by changing species of the fluorescent organic compound, it is possible to effect luminescence over broad wavelength regions ranging from an ultraviolet region to an infrared region. In this regard, various compounds have been extensively studied in recent years. Such compounds have been proposed in, e.g., U.S. Patent Nos. 5,151,629, 5,409,783 and 5,382,477, and Japanese Laid-Open Patent Applications (JP-A) 2-247278, JP-A 3-255190, JP-A 5-202356, JP-A 9-202878 and JP-A 9-227576.

In addition to the above-mentioned organic luminescence devices using low-molecular weight materials, an organic luminescence device using a conjugated polymer has been reported by a research group of Cambridge University ("Nature", vol. 347, pp. 539- (1990)). According to this report, a single layer of polyphenylenevinylene (PPV) is formed through a wet-coating process and luminescence from the single layer is confirmed. Such an organic luminescence device using a conjugated polymer has also been proposed by, e.g., U.S. Patent Nos. 5,247,190, 5,514,878 and 5,672,678, JP-A 4-145192, and JP-A 5-247460.

As described above, recent progress in organic luminescence device is noticeable, and the resultant organic luminescence devices are characterized by high luminance (brightness) under application of a low voltage, various (light-)emission wavelengths, high-speed responsiveness, small thickness and light weight, thus suggesting possibility of wide applications.

However, the above-described organic luminescence devices are still required to effect light output (emission) at a higher luminance and/or a higher conversion efficiency in the present state. These organic luminescence devices are also still insufficient in terms of durability such that the devices are liable to be changed in their properties with time when used for a long period or liable to be deteriorated by the influence of ambient air containing oxygen or of humidity. Further, for application to a full-color display, etc., it is necessary to effect luminescence of blue, green and red with good color purity, but a sufficient solution to this problem has not yet been provided.

Moreover, in most of conventional organic luminescence devices, organic films have been formed of molecules of organic compounds and are liable to cause agglomeration or crystallization of the molecules, thus resulting in a substantial number of local spots of luminescence failure in some cases.

Some examples of utilization of polymerized films in organic luminescence device have been reported (in Preprint for 59th Lecture Meeting of Applied Physics Society of Japan, No. 3, 1090 (1998), Preprint for 46th Joint Lecture Meeting of Applied Physics, Japan, No. 3, 1257 (1999), etc.) (JP 06 096860 A), but these polymerized films have been formed by vacuum deposition polymerization system and have left problems regarding polymerization control and productivity.

### SUMMARY OF THE INVENTION

In view of the above-mentioned state of art, an object of the present invention is to provide a process for producing an organic luminescence device capable of high-luminance light emission at a high efficiency while exhibiting a long life.

Another object of the present invention is to provide a process for producing an organic luminescence device capable of providing luminescence of various hues and also exhibiting excellent durability.

A further object of the present invention is to provide a process for producing such an organic luminescence device easily and relatively inexpensively.

According to an aspect of the present invention, there is provided a process for producing an organic luminescence device of the type comprising a pair of electrodes comprising an anode and a cathode, and at least one organic layer disposed between the electrodes, said process comprising:
a step of forming a film of organic compound in its monomer state having at least two polymerizable double bonds by application of a solution of said organic compound, and
a step of curing the film by irradiating the film with actinic light or electron ray to polymerize the organic compound, thereby providing at least one of said at least one organic layer.

As is understood from Examples and Comparative Example described hereinafter, the organic luminescence device produced according to the process of the present invention including a polymerized film of organic compound having at least two polymerizable double bonds exhibits luminescence of a high luminance at a low applied voltage and also excellent durability. The polymerized film can be formed through a wet coating process, thus allowing easy production of a large-area device relatively inexpensively.

These and other objects, features and advantages of the present invention will become more apparent upon a consideration of the following description of the preferred embodiments of the present invention taken in conjunction with the accompanying drawings.

### BRIEF DESCRIPTION OF THE DRAWING

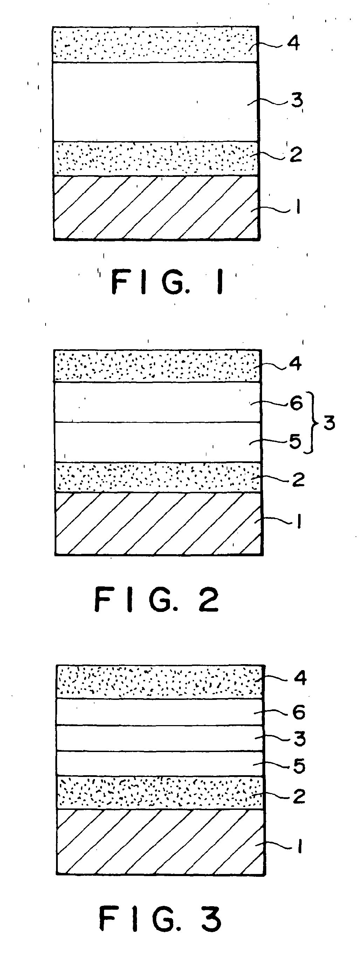

Figures 1 to 3 are schematic sectional views each illustrating a basic structure of an organic luminescence device according to an embodiment of the present invention.

### DESCRIPTION OF THE PREFERRED EMBODIMENTS

The organic luminescence device produced according to the process of the present invention comprises a pair of electrodes comprising an anode and a cathode, and at least one organic layer disposed between the electrodes, wherein said at least one organic layer includes at least one layer comprising a polymerized film of organic compound having at least two polymerizable double bonds.

The polymerizable double bond may preferably be a carbon-to-carbon double bond, preferred examples of which may include: optionally substituted (i.e., substituted or unsubstituted) vinyl group, and optionally substituted (i.e., substituted or unsubstituted) (meth)acrylate ester groups (i.e., acrylate ester group and methacrylate ester group).

The organic compound having at least two polymerizable double bonds can be embodied as any of a hole-transporting compound, an electron-transporting compound and a luminescent compound. Each functional compound can additionally have another function.

For providing a hole-transporting having at least two polymerizable double bonds, such at least two polymerizable double bonds may be introduced to a hole-transporting compound examples of which may include: triarylamine derivatives, tetraarylbiphenyl-diamine derivatives, stilbene-based arylamine derivatives and oligo-thiophene derivatives.

For providing an electron-transporting having at least two polymerizable double bonds, such at least two polymerizable double bonds may be introduced to an electron-transporting compound, examples of which may include: phenylenevinylene derivatives, benzoxazole derivatives, oxadiazole derivatives, thiadiazole derivatives, polyphenylene derivatives, pyridine derivatives, pyrazone derivatives, azomethin derivatives, fluorenone derivatives, fluorenylidene derivatives and perylene derivatives.

For providing a luminescent compound having at least two polymerizable double bonds, such at least two polymerizable double bonds may be introduced to a luminescent compound, examples of which may include: phenylenevinylene derivatives, condensed polycyclic aromatic derivatives, oligo-arylene derivatives, silole derivatives, quinacridone derivatives, stilbene derivatives, coumarin derivatives, pyran derivatives, benzopyran derivatives, oxazoline derivatives, porphyrin derivatives, pyrazine derivatives, organometallic complexes and perylene derivatives.

The polymerized film of such an organic compound having at least two polymerizable double bonds may be formed by once forming a film of the organic compound through a dry film-forming process or a wet film-forming process and then curing the film by polymerizing the organic compound.

By providing a functional organic compound having a hole-transporting function, an electron-transporting function or/and a luminescent function per se with plural polymerizable double bonds, forming a film of the organic compound in its monomer state and then curing the film by promoting the polymerization of the organic compound, it becomes possible to obviate the agglomeration or crystallization of the organic compound molecules, thus providing a very stable and durable functional film suitable for constituting an organic luminescence device.

Examples of the dry film-forming process (outside the invention) may include: physical vapor deposition processes such as vacuum deposition, ion plating, and molecular beam epitaxial growth; and chemical vapor deposition processes such as plasma polymerization. Examples of the wet film-forming process (outside the invention) may include: coating as by casting and spin coating, dipping, LB (Langmuir-Blodgett) technique, printing, and ink-jetting.

Among the above, the wet film-forming process is used in the invention, and particularly the coating, printing and ink jetting are preferred.

The curing of the organic compound film by polymerization may be accelerated by irradiation with actinic light, or electron ray (or beam). In the case of the photo-polymerization, it is possible to use an appropriate polymerization initiator.

The organic compound layer may be formed in a thickness of at most 10 µm, preferably at most 0.5 µm, more preferably 0.01 - 0.5 µm.

Hereinbelow, some example structures of organic luminescence device of the present invention will be described with reference to the drawing. Thus, referring to the drawing, the organic layer constituting the organic luminescence device of the present invention may have a single-layer structure as shown in Figure 1 or a laminate structure of two or more layers as shown in Figures 2 and 3.

More specifically, Figure 1 is a schematic sectional view illustrating an embodiment of the organic luminescence device obtained according to the present invention. Referring to Figure 1, the organic luminescence device includes a substrate 1, and an anode 2, a luminescence layer 3 and a cathode disposed in this order on the substrate 1 so as to form a laminate structure. The luminescence layer 3 may comprise a single species of luminescent material exhibiting a hole-transporting function, an electron-transporting function and a luminescence function in combination or a mixture of plural compounds exhibiting these functions, respectively.

Figure 2 is a sectional view showing a laminate structure of another embodiment of the organic luminescence device. Referring to Figure 2, the organic luminescence device includes a substrate 1, and an anode 2, a hole-transporting layer 5, an electron-transporting layer 6 and a cathode 4 disposed successively in this order on the substrate 1 so as to form a laminate structure, either one or both of the hole-transporting layer 5 and the electron-transporting layer 6 may contain a luminescent material also having a hole-transporting function and/or an electron-transporting function, respectively, for constituting a luminescence layer 3 in combination. One of the layers 6 and 5 may contain a material having no luminescent function but having a good electron-transporting or hole-transporting function.

Figure 3 is a sectional view showing still another embodiment of the organic luminescence device of the present invention. Referring to Figure 3, the organic luminescence device includes a substrate 1, and an anode 2, a hole-transporting layer 5, a luminescence layer 3, an electron-transporting layer 6 and a cathode 4 disposed successively in this order on the substrate 1 to form a laminate structure. In this embodiment, the carrier transporting functions and the luminescent function of the organic compound layer are separated and assigned to the respective layers. Each of the hole-transporting layer 5, the luminescence layer 3 and the electron-transporting layer 6 may contain a single species or plural species of compounds showing respectively expected functions so as to exhibit desired performances. More specifically, in the case of using plural species of compounds in combination, a lot of latitude is provided in selection of materials for each layer, and various compounds having different emission wavelengths can be used to provide a variety of luminescence hues. Further, as the carriers and excitons are effectively confined in the central luminescence layer 3, it is possible to increase the luminescence efficiency.

In any of the embodiments of Figures 1 - 3, each of the hole-transporting layer 5, the luminescence layer 3 and the electron-transporting layer 6 may have a thickness of 5 nm - 1 µm, preferably 10 - 500 nm.

It is to be understood however that Figures 1 - 3 described above merely show basic structures of the organic luminescence device obtainable by the present invention, and various modifications thereof are possible. For example, between the organic compound layer(s) and the electrodes (anode and cathode), it is possible to dispose an electron injection layer (on the cathode side), a hole injection layer (on the anode side), an insulating layer, an adhesive layer, or an interference layer. Further, the hole-transporting layer 5 can be divided into two layers with different ionization potentials.

The layer comprising the polymerized film of the organic compound having at least two polymerizable double bonds can be used to constitute any of the hole-injecting and transporting layer, the electron-transporting layer and the luminescence layer. However, the polymerized film of the organic compound having at least two polymerizable double bonds can also be used to constitute such a functional layer, as desired, in combination with a known hole-transporting compound, electron-transporting compound or luminescent compound, examples of which are enumerated hereinbelow.

### Hole-transporting materials (low-molecular weight)

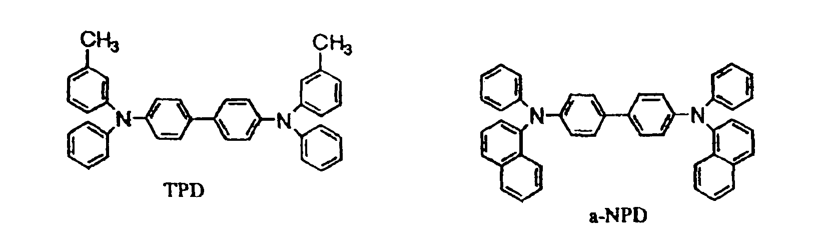

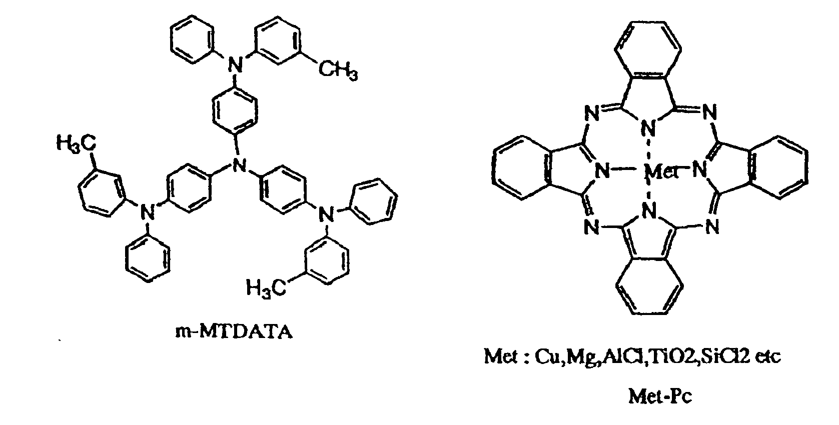

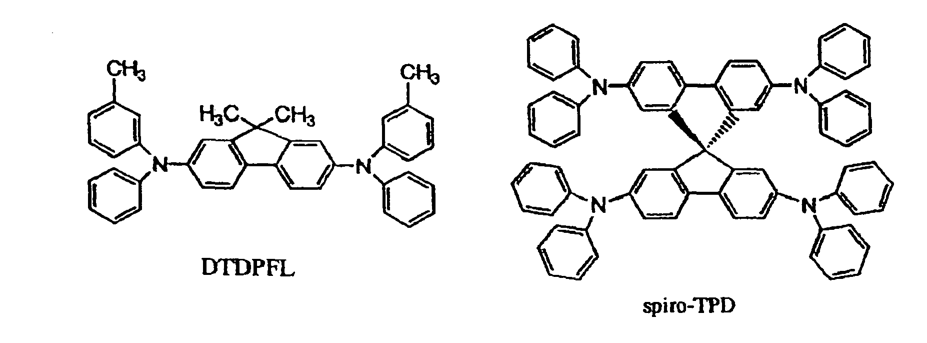

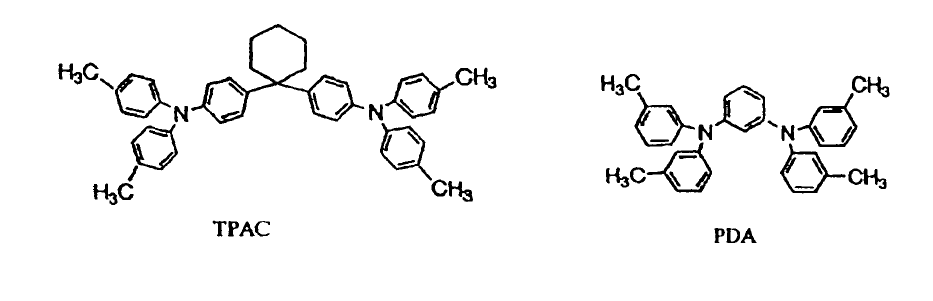

### Hole-transporting materials (polymeric)

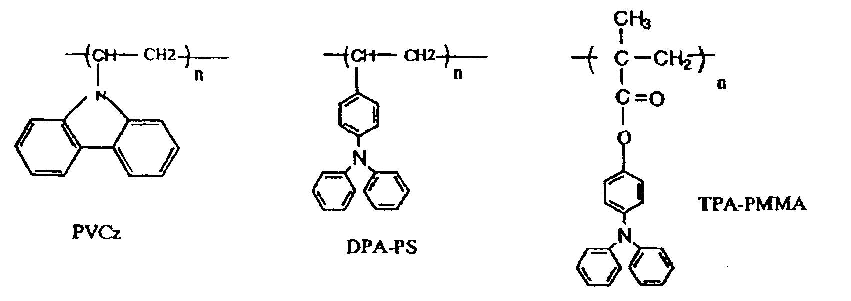

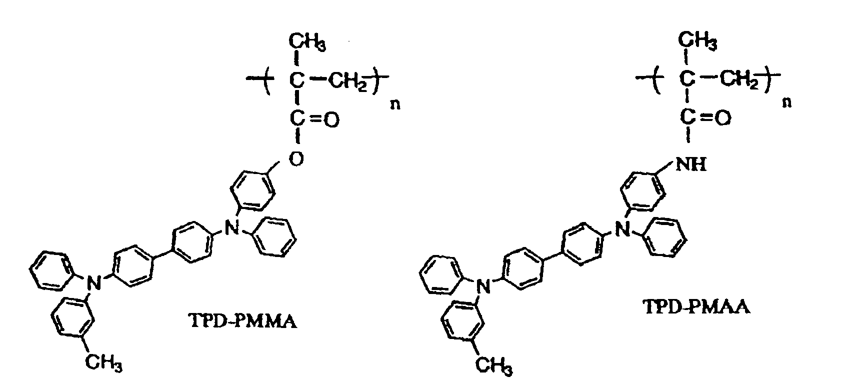

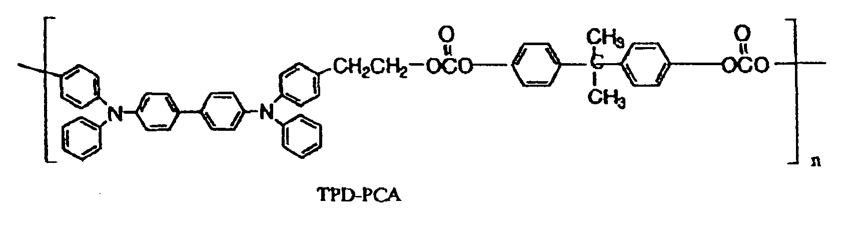

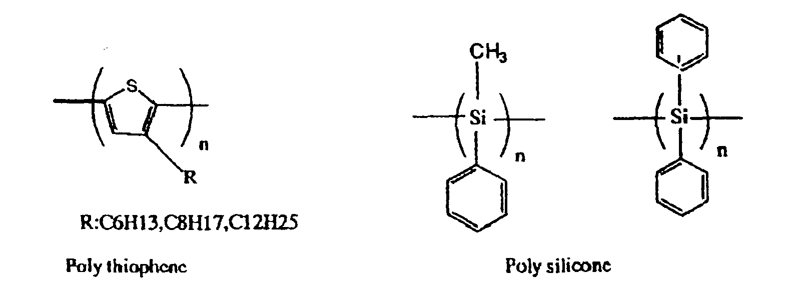

### Electron-transporting (luminescent) materials

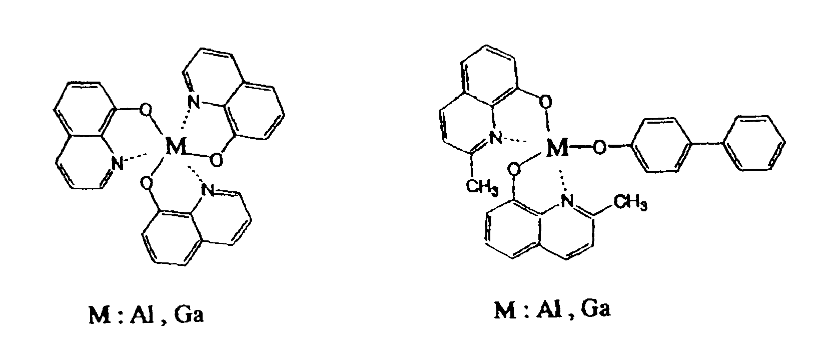

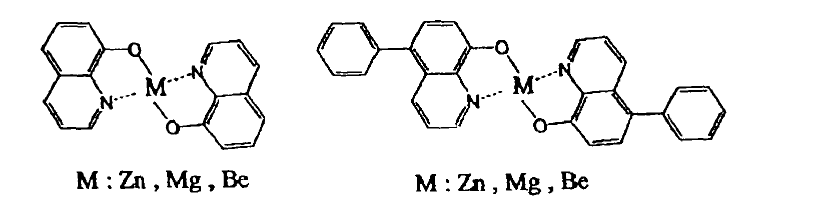

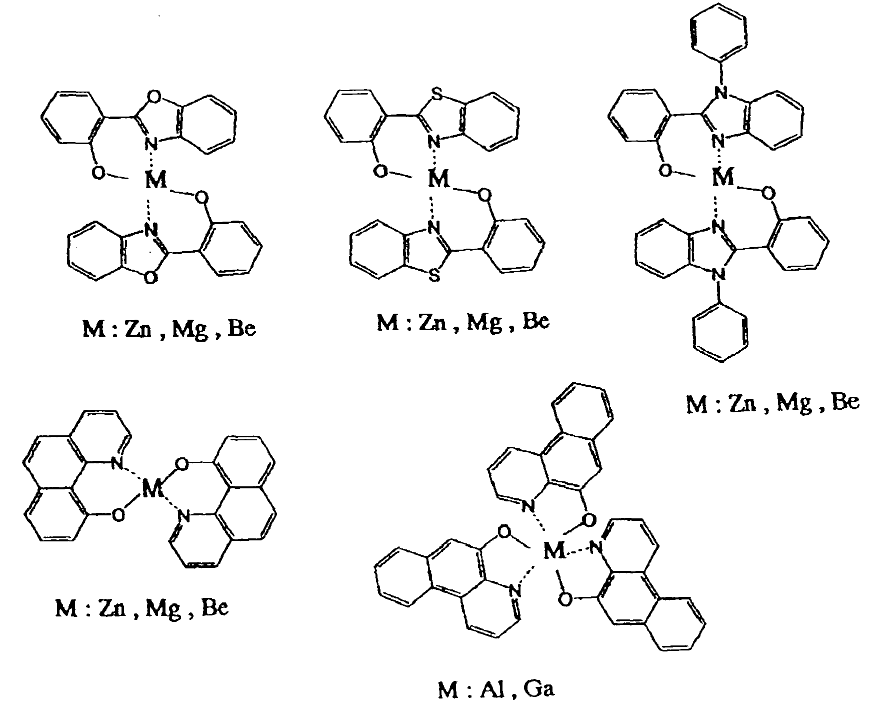

### Electron-transporting (luminescent) materials

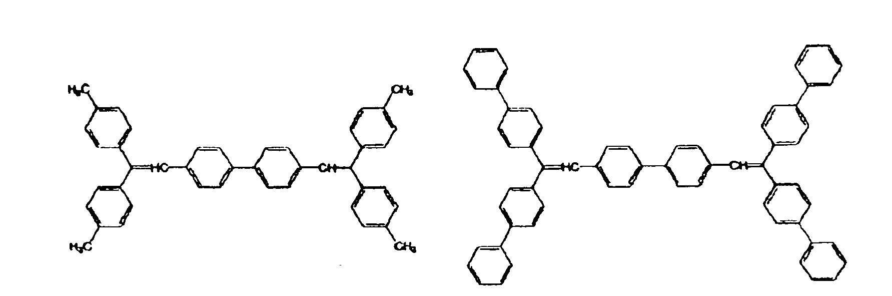

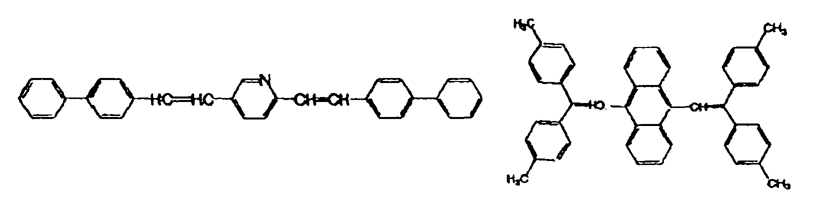

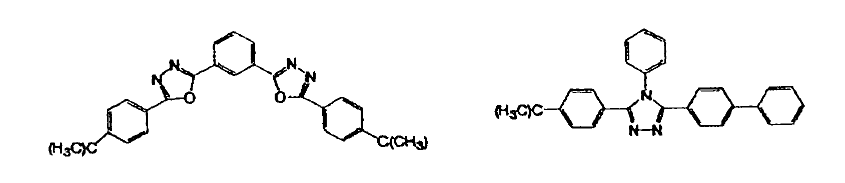

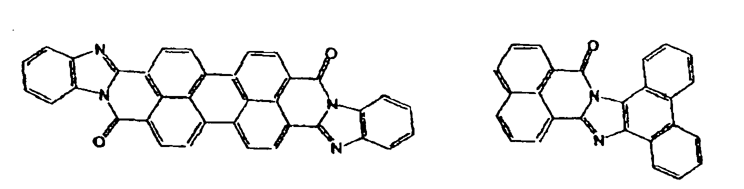

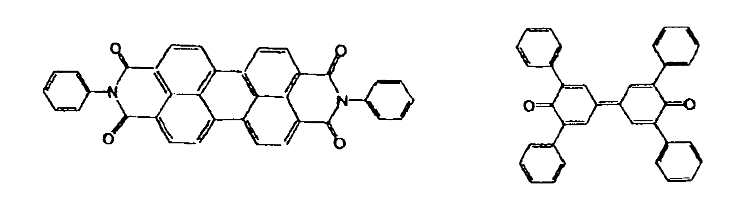

### Polymeric luminescent materials

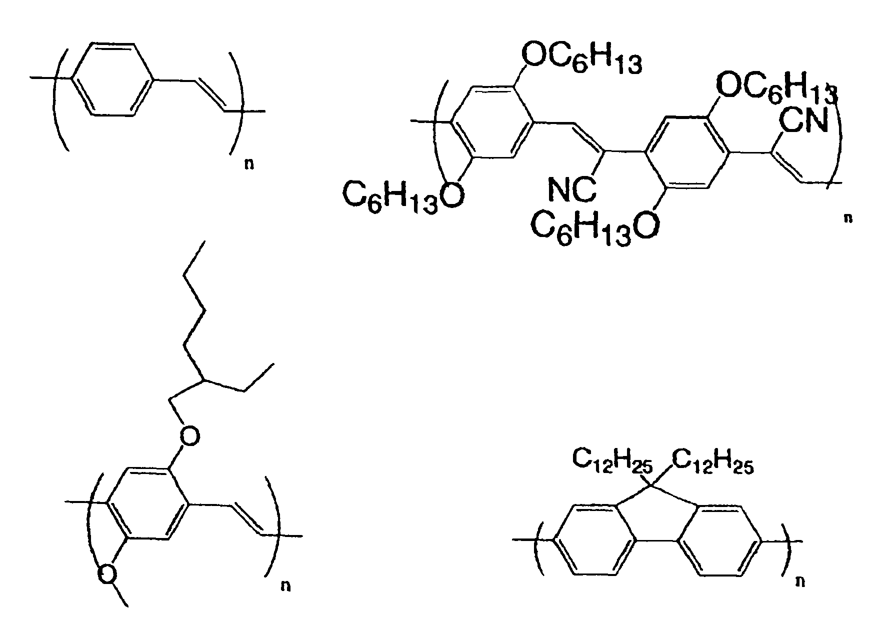

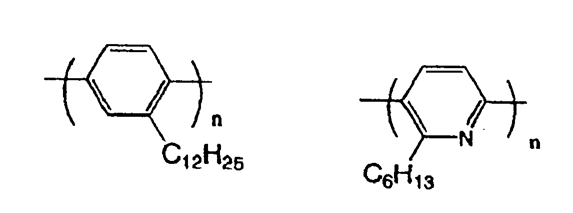

### Dopants

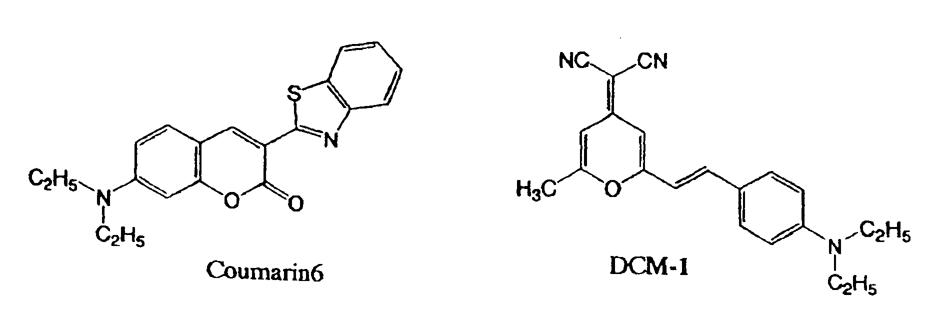

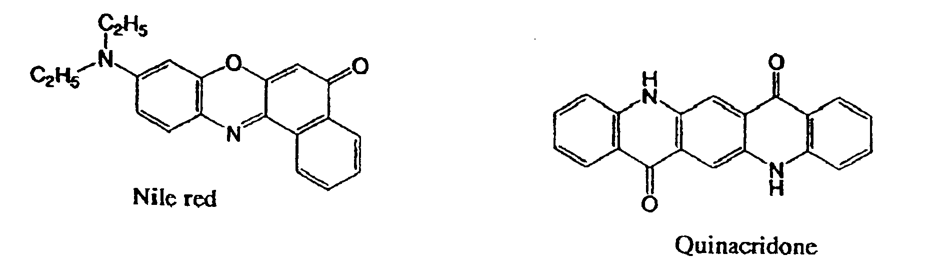

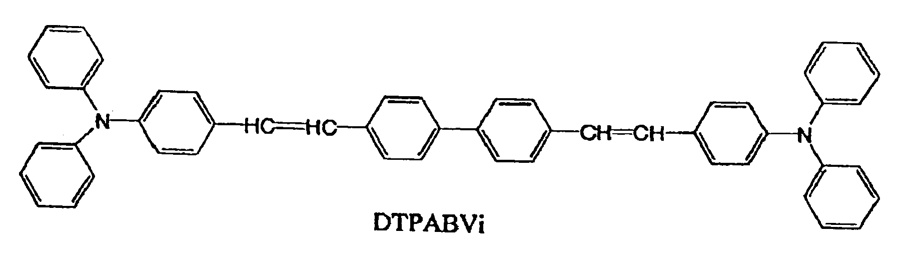

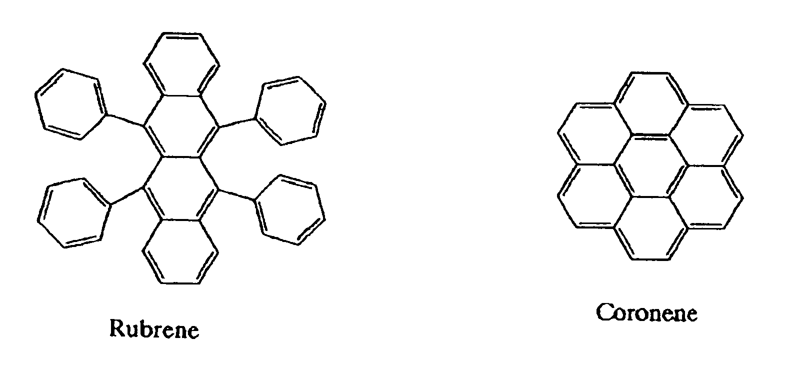

Further, in the case of constituting an organic luminescence device including two or more organic layers as shown in Figure 2 or 3, it is preferred that the polymerized film of organic compound having at least two polymerizable double bonds constitutes the first formed organic layer (i.e., the hole-transporting layer 5 in Figures 2 and 3), more preferably the first formed organic layer and the second formed organic layer (i.e., the hole-transporting layer 5 and the electron-transporting layer 6 in Figure 2; and the hole-transporting layer 5 and the luminescence layer 3 in Figure 3). In this instance, it is further preferred that the first formed organic layer comprises a polymerized film of organic compound having at least three polymerizable double bonds.

Further, in the case of constituting an organic luminescence device including three or more organic layers as shown in Figure 3, it is preferred that the polymerized film of organic compound having at least two polymerizable double bonds constitutes at least three organic layers.

In the organic luminescence device, an organic layer other than the organic layer(s) comprising the polymerized film of organic compound having at least two polymerizable double bonds may generally be formed into film by vacuum deposition or coating of a solution of the relevant compound in an appropriate solvent. In the case of the solution coating, the functional organic compound can be used in mixture with an appropriate binder resin to form a film. In this case, the organic compound may for example be used in 0.01 - 20 wt. parts, preferably, 0.1 - 10 wt. parts, per 1 wt. part of the binder resin.

The binder resin used for the above purpose may be selected from a wide variety of scope. Examples thereof may include: polyvinyl carbazole resin, polycarbonate resin, polyester resin, polyarylate resin, polystyrene resin, acrylic resin, methacrylic resin, butyral resin, polyvinyl acetal resin, diallyl phthalate resin, phenolic resin, epoxy resin, silicone resin, polysulfone resin, and urea resin. These resins may be used singly or in combination of two or more species or in the form of copolymers.

As a material for the anode (2 shown in Figures 1 - 3), it is preferred to use one having as large a work function as possible, examples of which may include: metals, such as gold, platinum, nickel, palladium, cobalt, selenium and vanadium, and their alloys; metal oxides, such as tin oxide, zinc oxide, indium tin oxide (ITO), and indium zinc oxide; and electroconductive polymers, such as polyaniline, polypyrrole, polythiophene, and polyphenylene sulfide. These compounds may be used singly or in combination of two or more species.

On the other hand, as a material for the cathode 4 shown in Figures 1 - 3, it is preferred to use one having a small work function, examples of which may include: metals, such as lithium, sodium, potassium, calcium, magnesium, aluminum, indium, silver, lead, tin and chromium, and their alloys. It is also possible to use metal oxide, such as indium tin oxide (ITO). The cathode may be formed in a single layer or a lamination of plural layers.

The substrate 1 shown in Figures 1 - 3 for the organic luminescence device may include an opaque substrate of metal, ceramics, etc., and a transparent substrate of glass, quartz, plastics, etc. It is possible to form the substrate with a color filter film, a fluorescent color conversion film, a dielectric reflection film, etc., thus controlling emitted luminescent light.

In order to prevent contact with oxygen and/or moisture, the organic luminescence device of the present invention may further include a protective layer or a sealing layer. Examples of the protective layer may include: an inorganic film of diamond, metal oxide, metal nitride, etc.; a polymer film of fluorine-containing resin, polyparaxylene, polyethylene, silicone resin, polystyrene, etc., and a film of light-curable resin. It is also possible to effect packaging of the organic luminescence device per se with a sealing resin while covering the organic luminescence device with glass, gas-impermeable film, metal, etc.

The organic layer in the luminescence device can be effectively formed through two steps of film formation and curing by polymerization, and the resultant organic layer is little liable to cause agglomeration or crystallization resulting in defects, so that the luminescence device can exhibit a much higher durability than the conventional device.

### <Synthesis example> Synthesis of N,N'-diphenyl-N,N'-bis(4-vinylphenyl)-4,4'-diamino-1,1-biphenyl (DPDVDAB).

Into a flask equipped with a drying tube, 4.6 g of DMF (dimethylformamide) was placed and cooled to 0 °C, and 27.0 g of phosphoryl chloride was added dropwise thereto. To the resultant solution, 4.88 g of N,N,N',N'-tetraphenyl-4,4'-diamino-1,1-biphenyl was added, and the mixture was stirred for 5 min. an then heated under reflux for 2 hours. The reaction mixture was poured into 200 ml of iced water, followed by stirring for 30 min. The resultant precipitate solid was filtered out, repetitively washed with water and then dried. The product solid was purified by silica gel column chromatography with ethyl-acetate and toluene as developing solvents, followed by condensation and crystallization by addition of hexane. The crystal was filtered out and dried to obtain 3.5 g (yield: 65.8 %) of yellow crystal of N,N'-diphenyl-N,N'-bis(4-formylphenyl)-4,4'-diamino-1,1-biphenyl.

Into a three-necked flask, 5.77 g of triphenylphosphine and 3.12 g of methyl iodide was added and stirred for 30 min. together with 30 ml of DMF. Too the resultant solution, 3.5 g of the above-prepared N,N'-diphenyl-N,N'-bis(4-formylphenyl)-4,4'-diamino-1,1-biphenyl was added, and a solution of 1.2 g of sodium methoxide in 10 ml of methanol was added dropwise thereto. After 30 min. of stirring at room temperature, the system was further stirred at 80 °C for 4 hours. The reaction liquid was poured into water and extracted with toluene. The resultant organic phase was washed three times with water and then purified by silica gel column chromatography with toluene and hexane as developing solvents, followed by condensation and crystallization by addition of hexane, to obtain 2.33 g (yield: 67.0 %) of N,N'-diphenyl-N,N'-bis(4-vinylphenyl)-4,4'-diamino-1,1-biphenyl.

### Reference Example 1

An organic luminescence device of a structure as shown in Figure 2 was prepared in the following manner.

A 1.1 mm-thick glass substrate coated with a 120 nm-thick film of ITO (indium tin oxide) formed by sputtering was successively washed with acetone and isopropyl alcohol (IPA) under application of ultrasonic wave and then washed with IPA under boiling, followed by drying and cleaning by UV/ozone (i.e., irradiation with ultraviolet rays in the ozone-containing atmosphere), to obtain a transparent conductive substrate (including a substrate 1 and an ITO anode 2 formed thereon).

N,N'-diphenyl-N,N'-bis(4-vinylphenyl)-4,4'-diamino-l,l'-biphenyl (DPDVDAB) as an organic layer having two polymerizable double bonds was dissolved at a concentration of 1.0 wt. % in toluene to form a coating liquid. The coating liquid was applied by spin coating (at 2000 rpm) on the above-treated ITO-coated transparent conductive substrate, followed by drying at 80 °C for 10 min. to form a film which was then heat-treated at 120 °C for 10 hours in a nitrogen atmosphere to form a 50 nm-thick polymerized film as a hole-transporting layer (layer 5).

Then, the polymerized film was coated by vacuum deposition first with aluminum trisquinolinol (Alq₃) at a film growth rate of 0.3 nm/sec to form a 50 nm-thick electron-transporting luminescent layer (layer 6) and then with Al-Li alloy (Li content = 1 atom %) at a film growth rate of 1.0 - 1.2 nm/sc to form a 150 nm-metal cathode film 4, thereby forming an organic luminescence device having a structure as shown in Figure 2. The vacuum deposition was respectively performed at a vacuum of 1.0x10⁻⁴ Pa.

### Reference Example 2

An ITO-coated transparent conductive substrate identical to the one used in Example 1 was coated with DPDVDAB used in Example 1 by vacuum deposition at a film growth rate of 0.3 nm/sec in a vacuum of 1.0x10⁻⁴ Pa to form a film thereof, which was then irradiated with ultraviolet rays for 5 min. and then heat-treated at 120 °C for 2 hours to form a 50 nm-thick polymerized film (as a hole-transporting layer 5).

Thereafter, the polymerized film was coated by vacuum deposition successively with a 50 nm-thick film of Alq₃ (electron-transporting luminescent layer 6) and a 150 nm-thick Al-Li alloy (cathode film 4) similarly as in Example 1 to form an organic luminescence device having a structure as shown in Figure 2.

### Comparative Example 1

An organic luminescence device having a structure as shown in Figure 2 was prepared in a similar manner as in Example 1 except for using N,N'-diphenyl-N,N'-bis(3-methylphenyl)-4,4'-diamino-1,1'-biphenyl instead of DPDVDAB and omitting the polymerization heating treatment for forming a hole-transporting layer 5.

The above-prepared organic luminescence devices of Examples 1-2 and Comparative Example 1 were subjected to 100 hours of continuous luminescence in vacuum while applying a DC voltage of 5 volts between the ITO anode 2 and the Al-Li alloy cathode 4 of each device. The results are inclusively shown in Table 1 below.

**Table 1**

| Example | Applied voltage | Luminance (cd/m²) | |
|---|---|---|---|
| | (V) | Initial | After 100 hours |
| 1 | 5.0 | 755 | 730 |
| 2 | 5.0 | 740 | 710 |
| Comp. 1 | 5.0 | 130 | 25 |

### Reference Example 3

1 wt. part of N,N'-diphenyl-N,N'-bis(4-vinylphenyl)-4,4'-diamino-1,1'-biphenyl (DPDVDAB) and 1 wt. part of methoxyethylhexyl-p-phenylene-vinylene (MEH-PPV) were dissolved in 148 wt. parts of paraxylene to form a coating liquid (solid content: 1.33 wt. %). The coating liquid was applied by spin coating (2000 rpm) on an ITO-coated transparent conductive substrate identical to the one used in Example 1, followed by drying at 80 °C for 10 min. and heat-treatment at 120 °C for 10 hours, respectively in a nitrogen atmosphere, to form a 70 nm-thick polymerized film.

Then, the polymerized film was coated with a 150 nm-thick cathode film (layer 4) of Al-Li alloy (Li content = 1 atm.%) by vacuum deposition at a film growth rate of 1.0 - 1.2 nm/sec in a vacuum of 1.0x10⁻⁴ Pa to form an organic luminescence device having a structure as shown in Figure 1.

The device was driven by applying a DC voltage of 10 volts between the ITO electrode 2 and the Al-Li cathode 4, whereby a current of 160 mA/cm² was flowed to exhibit orange luminescence at a luminance of 2700 cd/m².

### Reference Example 4

N,N,N',N'-tetrakis[3-methacryloyloxyphenyl]-4,4'-diamino-1,1'-biphenyl (TMDAB) and benzoyl peroxide (in 2 wt. % of TMDAB) were dissolved in toluene to form a 1.0 wt. %-coating liquid. The coating liquid was applied by spin coating (2000 rpm) on an ITO-coated transparent conductive substrate identical to the one used in Example 1, followed by drying at 80 °C for 10 min. and heat-treatment at 120 °C for 8 hours, respectively in a nitrogen atmosphere, to form a 65 nm-thick polymerized film (hole-transporting layer 5).

Then, 2,5-bis(4-styrylphenyl)-1,3,4-oxadiazole was dissolved in toluene to form a 1.0 wt. % coating liquid. The coating liquid was applied by spin-coating (2000 rpm) on the above formed hole-transporting layer (5), followed by drying at 80 °C for 3 hours and heat-treatment at 120 °C for 8 hours to form a 50 nm-thick polymerized film (electron-transporting luminescent layer 6).

Then, the polymerized film was coated with a 200 nm-thick cathode film of Mg/Ag alloy (9/1 by weight) by co-vacuum deposition at a film growth rate of 1.0 - 1.2 nm/sec in a vacuum of 1.0x10⁻⁴ Pa to form an organic luminescence device having a structure as shown in Figure 2.

The device was driven by applying a DC voltage of 10 volts between the ITO electrode 2 and the Mg/Ag-cathode, whereby a current of 230 mA/cm² was flowed to exhibit blue luminescence at a luminance of 3590 cd/m².

### Reference Example 5

The process of Example 4 was repeated up to the formation of the 65 nm-thick hole-transporting layer.

Then, 2,5-bis(4-styrylphenyl)-1,3,4-oxadiazole (BSOXD) and coumarin 6 (in 1 wt. % of BSOXD) were dissolved in toluene to form a 1.0 wt. %-coating liquid. The coating liquid was applied by spin coating (2000 rpm) on the above-formed hole-transporting layer, followed by drying at 80 °C for 3 hours and heat-treatment at 120 °C for 8 hours respectively in a nitrogen atmosphere, to form a 50 nm-thick polymerized film (electron-transporting luminescent layer 6).

Then, the polymerized film was coated with a 200 nm-thick cathode film of Mg/Ag alloy (9/1 by weight) by co-vacuum deposition at a film growth rate of 1.0 - 1.2 nm/sec in a vacuum of 1.0x10⁻⁴ Pa to form an organic luminescence device having a structure as shown in Figure 2.

The device was driven by applying a DC voltage of 10 volts between the ITO electrode 2 and the Mg/Ag-cathode, whereby a current of 280 mA/cm² was flowed to exhibit green luminescence at a luminance of 39000 cd/m².

### Reference Example 6

The process of Example 4 was repeated up to the formation of the 65 nm-thick hole-transporting layer.

Then, 2,5-bis(4-styrylphenyl)-1,3,4-oxadiazole (BSOXD) and 5,11-diphenyl-6,12-bis(4-vinylphenyl)naphthacene (in 1 wt. % of BSOXD) were dissolved in toluene to form a 1.0 wt. %-coating liquid. The coating liquid was applied by spin coating (2000 rpm) on the above-formed hole-transporting layer, followed by drying at 80 °C for 3 hours and heat-treatment at 120 °C for 8 hours respectively in a nitrogen atmosphere, to form a 50 nm-thick polymerized film (electron-transporting luminescent layer 6).

Then, the polymerized film was coated with a 200 nm-thick cathode film of Mg/Ag alloy (9/1 by weight) by co-vacuum deposition at a film growth rate of 1.0 - 1.2 nm/sec in a vacuum of 1.0x10⁻⁴ Pa to form an organic luminescence device having a structure as shown in Figure 2.

The device was driven by applying a DC voltage of 10 volts between the ITO electrode 2 and the Mg/Ag-cathode, whereby a current of 310 mA/cm² was flowed to exhibit yellow luminescence at a luminance of 42500 cd/m².

### Reference Example 7

N,N,N',N'-tetrakis[3-vinylphenyl]-4,4'-diamino-1,1'-biphenyl (TBDAB) and benzoyl peroxide (in 2 wt. % of TBDAB) were dissolved in toluene to form a 1.0 wt. %-coating liquid. The coating liquid was applied by spin coating (2000 rpm) on an ITO-coated transparent conductive substrate identical to the one used in Example 1, followed by drying at 80 °C for 10 min. and heat-treatment at 120 °C for 8 hours, respectively in a nitrogen atmosphere, to form a 55 nm-thick polymerized film (hole-transporting layer 5).

Then, 4,4'-bis[2-phenyl-2-(4-methacryloyl-oxyphenyl)]vinyl-1,1'-biphenyl (DPDMVB) and 5,11-diphenyl-6,12-bis(4-vinylphenyl)naphthacene (in 1 wt. % of DPDMVB) were dissolved in toluene to form a 0.2 wt. %-coating liquid. The coating liquid was applied by spin coating (2000 rpm) on the above-formed hole-transporting layer, followed by drying at 80 °C for 3 hours and heat-treatment at 120 °C for 8 hours to form a 15 nm-thick polymerized film (luminescent layer 3).

Then, 1,3,5-tris(4-vinylphenyl-1,3,4-oxadiazoyl)benzene was dissolved in toluene to form a 0.3 wt. %-coating liquid. The coating liquid was applied by spin coating (1500 rpm) on the above-formed luminescent layer, followed by drying at 80 °C for 3 hours and heat-treatment at 120 °C for 8 hours to form a 35 nm-thick polymerized film (electron-transporting layer 6).

Then, the polymerized film was coated with a 0.3 nm-thick lithium fluoride film and then with a 200 nm-thick Al cathode film by vacuum deposition at a film growth rate of 1.0 - 1.2 nm/sec in a vacuum of 1.0x10⁻⁴ Pa to form an organic luminescence device having a structure as shown in Figure 3.

The device was driven by applying a DC voltage of 13 volts between the ITO electrode 2 and the Al-cathode, whereby a current of 530 mA/cm² was flowed to exhibit red luminescence at a luminance of 26000 cd/m². Further, the device was continuously driven at a constant current of 50 mA/cm² whereby an initial luminance of 2500 cd/m² was only changed to 2450 cd/m² after 500 hours, thus showing a very small luminance lowering.

### Reference Example 8

The process of Example 7 was repeated up to the formation of the 55 nm-thick hole-transporting layer.

Then, DPDMVB used in Example 7 and Nile Red (in 1 wt. % of DPDMVB) were dissolved in toluene to form a 0.2 wt. %-coating liquid. The coating liquid was applied by spin coating (2000 rpm) on the above-formed hole-transporting layer, followed by drying at 80 °C for 3 hours and heat-treatment at 120 °C for 8 hours respectively in a nitrogen atmosphere, to form a 15 nm-thick polymerized film (luminescent layer 3).

Then, the polymerized film was coated with a 40 nm-thick layer of aluminum quinolinol (Alq₃) (electron-transporting layer 6).

Thereafter, the electron-transporting layer 6 was coated with a 0.3 nm-thick lithium fluoride layer and a 200 nm-thick Al cathode film 4 similarly as in Example 7 to form an organic luminescence device having a structure as shown in Figure 3.

The device was driven by applying a DC voltage of 13 volts between the ITO electrode 2 and the Al-cathode, whereby a current of 930 mA/cm² was flowed to exhibit yellow luminescence at a luminance of 139000 cd/m². Further, the device was continuously driven at a constant current of 50 mA/cm² whereby an initial luminance of 3100 cd/m² was only changed to 2950 cd/m² after 500 hours, thus showing a very small luminance lowering.

An organic luminescence device capable of luminescence at a high efficiency, a high luminance and high durability is formed by a pair of electrodes comprising an anode and a cathode, and at least one organic layer prepared according to the process of the present invention and being disposed between the electrodes. The at least one organic layer includes at least one layer comprising a polymerized film of organic layer having at least two polymerizable double bonds.

## Claims

1. A process for producing an organic luminescence device of the type comprising a pair of electrodes comprising an anode and a cathode, and at least one organic layer disposed between the electrodes, said process comprising:
a step of forming a film of organic compound in its monomer state having at least two polymerizable double bonds by application of a solution of said organic compound, and
a step of curing the film by irradiating the film with actinic light or electron ray to polymerize the organic compound, thereby providing at least one of said organic layers.

## Patentansprüche

1. Verfahren zur Herstellung einer organischen Lumineszenzeinrichtung des Typs enthaltend ein Elektrodenpaar, enthaltend eine Anode und eine Kathode, und mindestens eine zwischen den Elektroden angeordnete organische Schicht, das Verfahren enthaltend:
einen Schritt der Bildung eines Films einer organischen Verbindung mit mindestens zwei polymerisierbaren Doppelbindungen, in ihrem Monomerzustand, durch Einsatz einer Lösung der organischen Verbindung und
einen Schritt des Härtens des Films durch Bestrahlung des Films mit aktinischem Licht oder Elektronenstrahl, um die organische Verbindung zu polymerisieren, wodurch mindestens eine der organischen Schichten bereitgestellt wird.

## Revendications

1. Procédé de production d'un dispositif organique luminescent du type comprenant une paire d'électrodes comprenant une anode et une cathode, et au moins une couche organique disposée entre les électrodes, ledit procédé comprenant :
- une étape consistant à former un film d'un composé organique dans son état monomère ayant au moins deux doubles liaisons polymérisables par l'application d'une solution dudit composé organique, et
- une étape consistant à durcir le film en irradiant le film avec un rayonnement actinique lumineux ou électronique pour polymériser le composé organique, fournissant ainsi au moins une desdites couches organiques.
